# EUROPÄISCHE PATENTSCHRIFT

(11) **EP 3 149 468 B1**
(45) Veröffentlichungstag und Bekanntmachung des Hinweises auf die Patenterteilung: **06.01.2021**
(21) Anmeldenummer: 15726907.7
(22) Anmeldetag: 26.05.2015
(51) Int. Cl.: G01N 29/04, G01N 29/24, B06B 1/00

(54) **ANORDNUNG ZUR ZERSTÖRUNGSFREIEN WERKSTOFFPRÜFUNG**
ASSEMBLY FOR NONDESTRUCTIVE MATERIAL TESTING
ENSEMBLE POUR LE CONTRÔLE NON DESTRUCTIF DES MATÉRIAUX

(30) Priorität: 26.05.2014 DE 102014209990
(43) Veröffentlichungstag der Anmeldung: 05.04.2017
(73) Patentinhaber: Fraunhofer Gesellschaft zur Förderung der angewandten Forschung E.V., 80686 München (DE)
(72) Erfinder: KÖHLER, Bernd, 01259 Dresden (DE); SCHUBERT, Frank, 01279 Dresden (DE); LIESKE, Uwe, 01109 Dresden (DE)
(74) Vertreter: Pfenning, Meinig & Partner mbB
(86) Internationale Anmeldenummer: PCT/EP2015/061564
(87) Internationale Veröffentlichungsnummer: WO 2015/181152

(56) Entgegenhaltungen:
- EP-A2- 1 983 584
- DE-A1- 19 861 017
- US-A- 5 625 149
- US-A- 6 048 622
- US-A1- 2008 143 216
- "1-3 Piezo Composites & Transducers for Ultrasound Applications", , 27. April 2014 (2014-04-27), Seiten 1-8, XP055206534, Gefunden im Internet: URL:http://www.smart-material.com/media/Da tasheet/13K_V2.0-2014.pdf [gefunden am 2015-08-06]

## Beschreibung

Die Erfindung betrifft eine Anordnung zur zerstörungsfreien Werkstoffprüfung, mit der Scherwellen in elastische Oberflächen von Bauteilen oder Werkstücken emittiert und detektiert werden. Dabei werden piezoelektrische Wandlerelemente eingesetzt.

In der zerstörungsfreien Werkstoffprüfung werden piezoelektrische Wandler für das Emittieren und Einkoppeln von elastomechanischen Wellen in ein zu prüfendes Werkstück eingesetzt. Für bestimmte Prüfaufgaben ist die Ausbildung von Scherwellen erforderlich und vorteilhaft. Diese Scherwellen bewirken Teilchenauslenkungen senkrecht zu ihrer Ausbreitungsrichtung. Dabei sind zwei Polarisationen, nämlich vertikal polarisierte Scherwellen (SV) und horizontal polarisierte Scherwellen (SH) möglich. Bei horizontal polarisierten Scherwellen liegt die Schwingungsrichtung in der Einschallebene, Solche SH-Wellen eignen sich insbesondere zur Detektion von Rissen, als eine Form von Defekten, in Rohrleitungen und Schweißnähten. SH-Wellen sind dispersionsfrei und daher sehr langreichweitig. Außerdem wechselwirken sie nicht mit fluiden Medien, die von außen oder innen an das Bauteil angrenzen.

SH-Scherwellen können durch Ausnutzung des Schereffekts in piezoelektrischen Werkstoffen oder durch den Einsatz von elektromagnetischen Ultraschallwandlern ausgebildet werden. Die Erfindung zielt dabei auf die Verbesserungen bei der Ausbildung von Scherwellen mit piezoelektrischen Wandlern.

Nachteilig an piezoelektrischen Wandlern, bei denen die Scherung durch den d15 Effekt ausgelöst wird, ist die Tatsache, dass die Wandleroberseite durch eine relativ große seismische Masse belastet werden muss oder eine Fixierung, mit der Scherung behindert wird, am Wandler vorgenommen werden muss, damit die Scherwellen in das zu prüfende Werkstück übertragen werden können.

Der piezoelektrische Effekt verknüpft elektrische und mechanische Größen miteinander. Eine mechanische Verformung wird durch die Piezokeramik in ein elektrisches Signal umgewandelt und umgekehrt. Das Sensor- und Aktorverhalten dieser Werkstoffe ermöglicht eine Vielzahl von Anwendungen im Bereich der Elektrotechnik, Akustik, Automatisierungstechnik, Nachrichtentechnik, im Automobilbau und in weiteren Einsatzgebieten. Dabei kommen piezokeramische Sensoren und Aktoren sowie komplexe piezokeramische Baugruppen und Systeme zur Anwendung.

Die Verformung, die durch Anlegen einer elektrischen Spannung und Ausbildung eines elektrischen Feldes verursacht wird, wird üblicherweise durch Indizes in Vogt-Notation gekennzeichnet, wobei der erste Index die Ursache, d.h. die Richtung des elektrischen Feldes und der zweite Index die Wirkung, d.h. die Richtung der Verformung des piezoelektrischen Werkstoffs angibt.

Neben der Verwendung von piezoelektrischen Wandlern als Dickenschwinger (d33), d.h. Anlegen eines elektrischen Feldes in Richtung der Polarisation des Wandlers bzw, die durch Querkontraktion hervorgerufene laterale Längenänderung (d31, d32), sind Anwendungen möglich, bei denen eine Scherung des Wandlers erwünscht ist. Durch Ausbildung eines elektrischen Feldes quer zur Polarisationsachse scheren Ober- und Unterseite des Wandlers in entgegengesetzte Richtungen (d15). Wird eine dieser Wandlerflächen auf das Untersuchungsobjekt mittels Klebung oder hoch-viskosen Flüssigkeiten aufgebracht und die Gegenseite mechanisch oder über Trägheit festgehalten, so werden horizontale Kräfte in das Objekt eingebracht, die SH-Scherwellen anregen. Die SH-Scherwellen werden dabei bisher mittels des d15 Effektes ausgebildet.

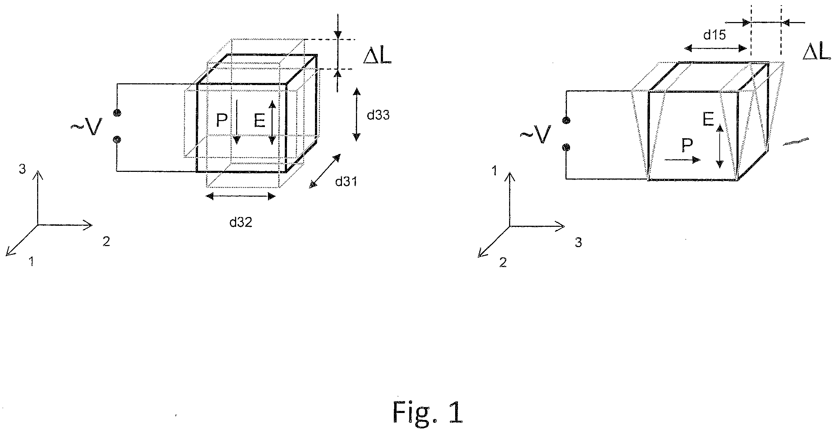

Möglichkeiten und entsprechende Verformungen sind in Figur 1 gezeigt.

Eine Alternative zu piezoelektrischen Wandlern stellen elektromagnetische Ultraschallwandler dar, die ebenfalls zur Einbringung von oberflächenparallelen Kräften in metallische Oberflächen genutzt werden können. Dies beruht u.a. auf dem Lorenzeffekt und Magnetostriktion, setzt aber die elektrische Leitfähigkeit des Untersuchungsobjektes/Werkstücks voraus.

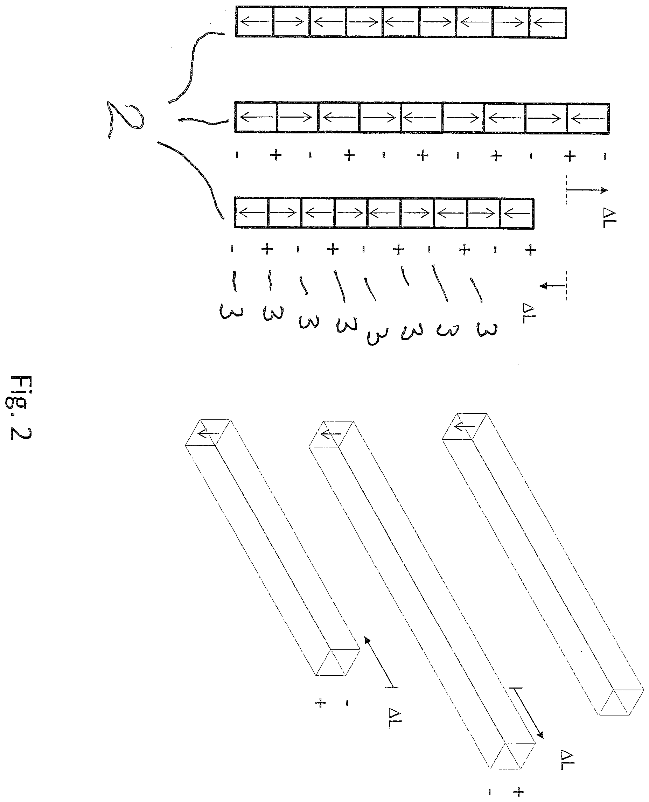

Piezoelektrische Fasern werden eingesetzt, um dünne, flexible und leichte Sensoren zu realisieren. Mit ihnen kann zudem die Querkontraktion eines Wandlers gering gehalten und hauptsächlich eine Verformung in Faserachslängsrichtung erreicht werden. Eine Längenänderung der piezoelektrischen Faser kann dabei durch zwei Möglichkeiten erfolgen. Zum einen kann durch eine alternierende Polarisation in Faserachslängsrichtung und mit Elektrodenfingern, an denen jeweils eine alternierend wechselnde elektrische Spannung anliegt, ein jeweils parallel zur Polarisation gerichtetes elektrisches Feld generiert werden, wodurch eine Längenänderung der piezoelektrischen Faser erreicht werden kann (d33, Figur 2 links). Zum anderen kann durch eine in Dickenrichtung polarisierte piezoelektrische Faser und durch ausbilden eines elektrischen Feldes über die Faserdicke eine Längenänderung erreicht werden (d31, Figur 2 rechts).

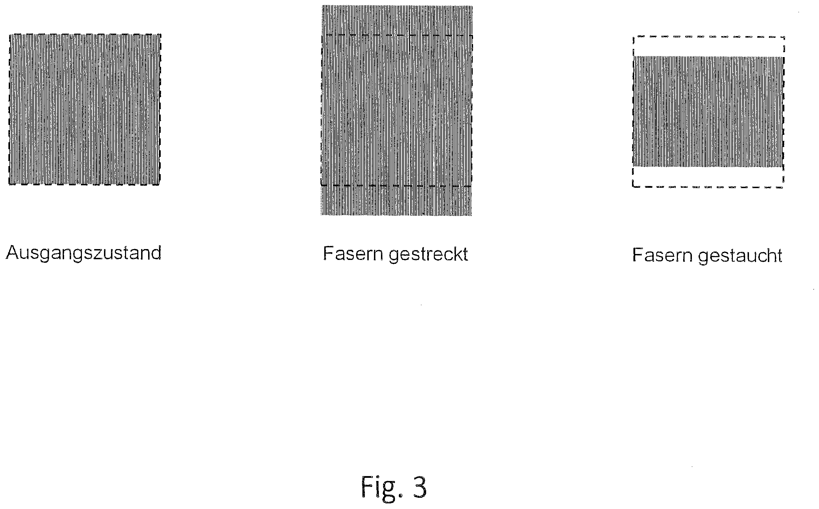

Bei Einsatz von parallel angeordneten piezoelektrischen Fasern kann durch Anlegen einer elektrischen Wechselspannung eine Längenänderung entlang der Faserrichtung erreicht werden. Eine solche Anordnung kann bevorzugt zur Ausbildung von Kompressionswellen (Longitudinalwellen) in Oberflächen von Werkstücken oder Bauteilen eingesetzt werden, die sich in Faserrichtung ausbreiten (Figur 3).

Die Verwendung von Fasern in Einzellagen in einer gemeinsamen Ebene zur gezielten Anregung bestimmter Wellenrnoden ist Stand der Technik. Einlagige Wandler mit piezoelektrischen Fasern sind kommerziell erhältlich.

Mit den bekannten Techniken ist eine Ausbildung von SH-Scherwellen in Werkstücken oder Bauteilen nur sehr ineffektiv möglich. Außerdem bestehen Defizite bei der Einhaltung von bevorzugten Polarisationsachsrichtungen, so dass bestimmte Defekte, insbesondere Risse, nicht mit ausreichender Sicherheit erkannt werden.

So ist aus US 5 625 149 A ein Ultraschall-Wandler in Mehrschichttechnik bekannt.

EP 1 983 584 A2 betrifft einen piezoelektrischen Faserkompositaktuator,

Eine piezoelektrische Kompositvorrichtung ist in US 2008/0143216 A1 beschrieben.

1-3 Piezokomposite sind in "1-3 Piezo Composites & transducers for Ultrasound Applications"; 27. April 2014; Seiten 1-8; YP055206S34; In URL:http://www.smart-material.com/mcdia/Datasheet/13K_V2.0-2014.pdf offenbart.

Komposite für eine Kontrolle von Strukturen sind in US 6 048 622 A beschrieben.

De 198 61017 A1 betrifft Ultraschall-Leistungswandler.

Es ist daher Aufgabe der Erfindung, eine verbesserte Anordnung mit piezoelektrischen Wandlerelementen anzugeben, mit der eine verbesserte Ausbildung von Scherwellen, insbesondere SH-Scherwellen möglich ist, mit denen die Sensitivität bei der zerstörungsfreien Prüfung und bei der Zustandsüberwachung erhöht werden kann.

Erfindungsgemäß wird diese Aufgabe mit einer Anordnung von piezoelektrischen Wandlern, die die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Bei der erfindungsgemäßen Anordnung zur zerstörungsfreien Werkstoffprüfung mit der Scherwellen in elastische Oberflächen von Bauteilen oder Werkstücken emittiert und detektiert werden können, sind piezoelektrische Wandlerelemente in mehreren Ebenen übereinander angeordnet und die piezoelektrischen Wandlerelemente, die in benachbarten Ebenen angeordnet sind, werden jeweils entgegengesetzt zueinander betrieben. Dies bedeutet, dass in einer Ebene eine Verlängerung und in der benachbarten Ebene gleichzeitig eine Verkürzung der Länge eines bzw. mehrerer piezoelektrischer Wandlerelemente in mindestens einer Achsrichtung hervorgerufen wird. Dabei sind die piezoelektrischen Wandlerelemente piezoelektrische Fasern und/oder piezoelektrische plättchenförmige Elemente, die mit einem elastisch verformbaren Werkstoff verbunden oder darin eingebettet sind. Bei dem elastisch verformbaren Werkstoff kann es sich um ein geeignetes Polymer, z.B. Polyimid oder Polyethylen handeln.

Piezoelektrische Fasern sollten jeweils in einer Ebene parallel zueinander und piezoelektrische Fasern in einer benachbarten Ebene in einem Winkel geneigt zu den piezoelektrischen Fasern, die in der jeweils anderen Ebene angeordnet sind, ausgerichtet sein. Bevorzugt ist eine um 90° versetzte Ausrichtung von piezoelektrischen Fasern in den benachbarten Ebenen.

An piezoelektrischen Fasern, die in benachbarten Ebenen angeordnet sind, können Elektroden mit einer Ausrichtung, die in einem Winkel zu den Faserlängsachsen beider Ebenen geneigt ist, vorhanden sein.

Die Elektroden sollten bevorzugt um 45° zu den Faserachsen geneigt orientiert sein.

An plättchenförmigen piezoelektrischen Elementen, die in benachbarten Ebenen angeordnet sind, können Elektroden mit einer Ausrichtung, die jeweils in einem Winkel zueinander geneigt ist, vorhanden sein. Die Elektroden können ähnlich, wie die piezoelektrischen Fasern ausgerichtet sein.

Bei der Erfindung besteht die Möglichkeit, in einer Ebene entsprechend ausgerichtete piezoelektrische Fasern und in einer benachbarten Ebene ein plättchenförmiges piezoelektrisches Wandlerelement einzusetzen.

An den einzelnen piezoelektrischen Wandlerelementen, also Fasern und Plättchen, können mehrere Elektroden, die in einem Abstand zueinander angeordnet sind, vorhanden sein. Bevorzugt weisen die Elektroden unterschiedlich große Abstände zueinander auf.

Die Anordnung kann bevorzugt rechteckig oder quadratisch ausgebildet sein.

Plättchenförmige piezoelektrische Wandlerelemente sollen eine Dicke aufweisen, mit der eine Streckung oder Verkürzung bei angelegter elektrischer Spannung und/oder Ausbildung mindestens eines elektrischen Feldes in mindestens eine Achsrichtung erreichbar ist. So kann ein plättchenförmiges piezoelektrisches Wandlerelement durch die wirkenden Kräfte in seiner Dicke verändert werden, so dass bei einem Zusammenpressen die Dicke verringert und eine Verlängerung des plättchenförmigen Wandlerelements erreicht wird. Bei entsprechend entgegengesetzter Kraftwirkung eines oder mehrerer elektrischer Felder kann die Dicke vergrößert werden, was zu einer Verkürzung führt.

Eine erfindungsgemäße Anordnung ist mit einem Werkstück oder Bauteil dauerhaft stoff- und/oder formschlüssig verbunden, so dass eine permanente Prüfung und Überwachung des Zustands möglich ist.

Die Erfindung nutzt die aus der Laminattheorie bekannten Zusammenhänge, um durch die Anordnungen von piezoelektrischen Fasern in unterschiedlicher Orientierung und/oder plättchenförmigen Elementen und in mehreren Lagen zusätzlich Anisotropie im Wandlerverbund zu erreichen und damit gezielt Verformungen der Anordnung und der Wandlerelemente zu ermöglichen, die im Vollmaterial (homogen) nicht möglich sind.

Scherung kann ebenfalls durch die Verwendung von Fasern, die in bestimmte Richtungen zueinander gelegt sind oder durch die gezielte Elektrodenstrukturierung erreicht werden.

Durch die Verwendung von zwei Lagen piezoelektrisch aktiven Werkstoffs, die beispielsweise bei einer quadratischen Wandlergrundfläche entlang der Diagonalen orientiert sind, kann durch Anlegen entgegengesetzt orientierter elektrischen Felder der beiden Lagen eine Scherung entlang einer Diagonale erreicht werden. Durch Umkehr der Vorzeichen/Polarität der jeweiligen elektrischen Felder kann eine Scherung entlang der anderen Diagonalen erreicht werden.

Die hier für den direkten piezoelektrischen Effekt beschriebene Funktionalität (Deformation durch Anlegen einer elektrischen Spannung) ist umkehrbar (inverser Effekt, elektrische Spannung infolge Scherdeformation).

Wie andere piezoelektrische Wandler kann eine erfindungsgemäße Anordnung statisch eingesetzt werden und/oder dynamisch zur Anregung bzw. der Detektion von elastischen Wellen genutzt werden.

Nachfolgend soll die Erfindung beispielhaft näher erläutert werden.

Dabei zeigen:
- Figur 1: in schematischer perspektivischer Darstellung mögliche Verformungen, die durch den Einfluss elektrischer Felder an einem würfelförmigen piezoelektrischen Wandlerelelement hervorgerufen werden können;
- Figur 2: Möglichkeiten für eine elektrische Ansteuerung über mehrere Elektroden an einem bei der Erfindung einsetzbaren piezoelektrischen Wandlerelement;
- Figur 3: Möglichkeiten zur Ausbildung von Kompressionswellen mit mehreren In einer Ebene und parallel zueinander angeordneten piezoelektrischen Fasern und
- Figur 4: ein Beispiel einer erfindungsgemäßen Anordnung, bei der piezoelektrische Fasern parallel zueinander in einer Ebene und in einer benachbarten Ebene piezoelektrische Fasern mit unterschiedlicher Winkelausrichtung vorhanden sind.

In Figur 2 ist ein Beispiel eines piezoelektrischen Wandlerelements 2, das eine Faser oder plättchenförmig sein kann, gezeigt, bei dem über die Länge mehrere Elektroden 3 angeordnet sind, an die jeweils eine elektrische Spannung angelegt werden kann. In der linken Darstellung liegt keine elektrische Spannung an, 50 dass das Wandlerelement 2 die Länge L aufweist. Bei den beiden weiter rechts gezeigten Zuständen, liegen elektrische Spannungen an den Elektroden 3 an, so dass bei der mittleren Darstellung die Länge L um einen Betrag ΔL verlängert und bei der rechten Darstellung um ΔL verkürzt ist.

In Figur 3 sind mögliche Verformungen von piezoelektrischen Fasern, die parallel zueinander und in einer Ebene angeordnet sind, dargestellt. Im Ausgangszustand ist eine quadratische Form eingehalten, bei entsprechend an Elektroden angelegten elektrischen Spannungen können die piezoelektrischen Fasern verlängert werden (mittlere Darstellung), so dass eine rechteckige Form erreicht wird. Bei einem anderen Anschluss elektrischer Spannung verkürzen sich die piezoelektrischen Fasern (rechte Darstellung), wodurch wiederum eine rechteckige Form erreicht wird, die aber im Gegensatz zur mittleren Darstellung andere Kantenlängen hat.

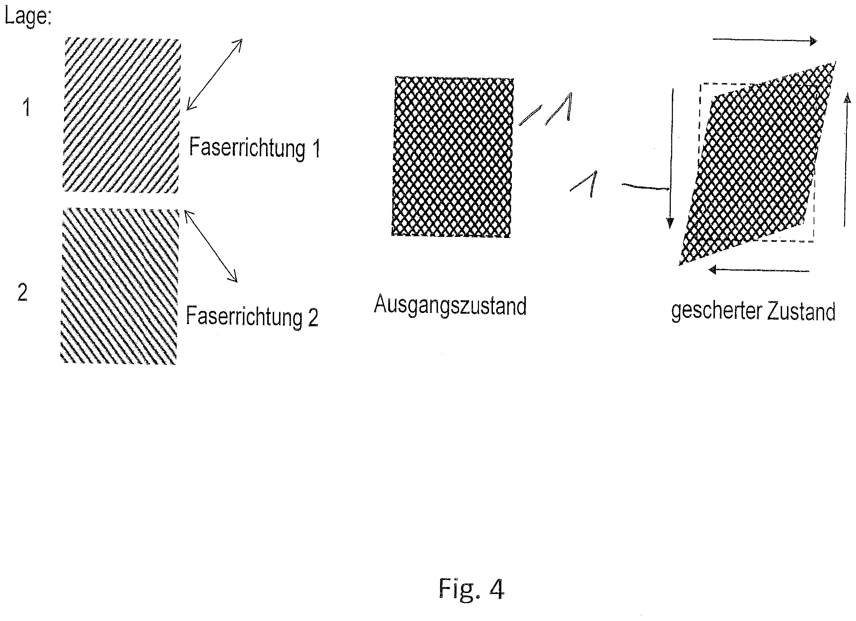

In Figur 4 ist eine Möglichkeit für eine erfindungsgemäße Anordnung, die mit piezoelektrischen Fasern gebildet ist, schematisch, mit einem Ausgangszustand und einem durch Verformung erreichbaren Zustand, bei dem SH-Scherwellen emittiert werden können, gezeigt.

In Figur 4 ganz links sind mehrere parallel zueinander angeordnete piezoelektrische Fasern mit ihrer Faserausrichtung in zwei Ebenen schematisch übereinander als Lage 1 und 2 gezeigt. Es ist deutlich erkennbar, dass die Ausrichtung der Fasern in den beiden Ebenen, also der Lage 1 und 2 senkrecht zueinander gewählt ist. Beide Lagen werden für eine erfindungsgemäße Anordnung 1 übereinander angeordnet, was schematisch aus der mittleren Darstellung hervorgeht und den Ausgangszustand darstellt, bei dem kein elektrisches Feld wirkt und keine elektrischen Spannungen angeschlossen sind. Wird aber eine elektrische Spannung angelegt und es wirkt mindestens ein elektrisches Feld, so verkürzen sich die piezoelelektrischen Fasern in einer Ebene (Lage 1), während sie gleichzeitig in der anderen Ebene (Lage 2) verlängert werden. Dadurch wird eine Verformung bewirkt, wie sie in der rechten Darstellung von Figur 4 gezeigt ist. Bei entsprechender Ankopplung oder Befestigung einer solchen Anordnung 1 können SH-Scherwelten in ein Werkstück oder Bauteil emittiert werden, wenn die Verformung mehrmals zwischen dem verformten und dem Ausgangszustand wechselt, was durch entsprechende Beeinflussung der elektrischen Spannung erreicht werden kann. Die Richtung der Verformung kann durch Wahl der Verkürzung oder Verlängerung der piezoelektrischen Wandlerelemente 2, die in diesem Fall die Fasern sind, in den verschiedenen Ebenen beeinflusst werden. So kann einmal eine Verlängerung in der oberen Ebene mit einer Verkürzung in der unteren Ebene oder entsprechend umgekehrt in den Ebenen gewählt werden.

Eine erfindungsgemäße Anordnung 1 kann dabei mit ausreichender Kraft gegen eine Oberfläche eines Werkstücks oder Bauteils gedrückt werden. Es besteht aber auch, wie im allgemeinen Teil der Beschreibung angesprochen, die Möglichkeit, die Anordnung 1 stoff- und/oder formschlüssig daran zu befestigen.

Prinzipiell kann in den Ebenen jeweils auch ein entsprechendes plättchenförmiges piezoelektrisches Wandlerelement eingesetzt werden, wobei das in der einen Ebene durch Anschluss elektrischer Spannung verkürzt und gleichzeitig ein in der darunter oder darüber angeordneten Ebene ein plättchenförmiges piezoelektrisches Element verlängert wird.

## Patentansprüche

1. Anordnung zur zerstörungsfreien Werkstoffprüfung, mit der Scherwellen in elastische Oberflächen von Bauteilen oder Werkstücken emittiert und detektiert werden, mit einer Anordnung (1) von piezoelektrischen Wandlerelementen und einem Bauteil oder Werkstück, bei der piezoelektrische Wandlerelemente (2) in mehreren Ebenen übereinander angeordnet und die piezoelektrischen Wandlerelemente (2) piezoelektrische Fasern und/oder piezoelektrische plättchenförmige Elemente sind, die mit einem elastisch verformbaren Werkstoff verbunden oder darin eingebettet sind; und
piezoelektrische Fasern jeweils in einer Ebene parallel zueinander und piezoelektrische Fasern in einer benachbarten Ebene in einem Winkel geneigt zu den piezoelektrischen Fasern, die in der jeweils anderen Ebene angeordnet sind, ausgerichtet sind,
oder
plättchenförmige piezoelektrische Wandlerelemente eine Dicke aufweisen, mit der eine Streckung oder Verkürzung bei angelegter elektrischer Spannung und/oder Ausbildung mindestens eines elektrischen Feldes in mindestens eine Achsrichtung erreichbar ist,
und
die piezoelektrischen Wandlerelemente (2), die in benachbarten Ebenen angeordnet sind, jeweils entgegengesetzt zueinander betreibbar sind, so dass in einer Ebene eine Verlängerung und in der benachbarten Ebene gleichzeitig eine Verkürzung der Länge eines oder mehrerer piezoelektrischer Wandlerelemente (2) in mindestens einer Achsrichtung hervorgerufen wird und die Anordnung (1) mit dem Werkstück oder Bauteil dauerhaft stoff- und/oder formschlüssig verbunden ist.

2. Anordnung nach Anspruch 1, **dadurch gekennzeichnet, dass** an piezoelektrischen Fasern, die in benachbarten Ebenen angeordnet sind, Elektroden mit einer Ausrichtung, die in einem Winkel zu den Faserlängsachsen beider Ebenen geneigt ist, vorhanden sind.

3. Anordnung nach einem der vorhergehenden Ansprüche, **dadurch gekennzeichnet, dass** an plättchenförmigen piezoelektrischen Elementen, die in benachbarten Ebenen angeordnet sind, Elektroden (3) mit einer Ausrichtung, die jeweils in einem Winkel zueinander geneigt ist, vorhanden sind.

4. Anordnung nach einem der vorhergehenden Ansprüche, **dadurch gekennzeichnet, dass** an den einzelnen piezoelektrischen Wandlerelementen (2) mehrere Elektroden(3), die in einem Abstand zueinander angeordnet sind, vorhanden sind.

5. Anordnung nach dem vorhergehenden Anspruch, **dadurch gekennzeichnet, dass** die Abstände zwischen Elektroden (3) unterschiedlich groß sind.

6. Anordnung nach einem der vorhergehenden Ansprüche, **dadurch gekennzeichnet, dass** die Anordnung (1) rechteckig oder quadratisch ausgebildet ist.

## Claims

1. An assembly for nondestructive material testing with which shear waves are emitted and detected in elastic surfaces of components or workpieces, with an assembly (1) of piezoelectric transducer elements and one component or workpiece, in which piezoelectric transducer elements (2) are arranged above one another in multiple planes and the piezoelectric transducer elements (2) are piezoelectric fibers and/or piezoelectric plate-like elements that
are connected to or embedded in an elastically deformable material; and
piezoelectric fibers are respectively aligned in a plane in parallel with one another and piezoelectric fibers are aligned in an adjacent plane inclined at an angle to the piezoelectric fibers that are arranged in the respective other plane,
or
plate-like piezoelectric transducer elements have a thickness with which a stretching or shortening can be achieved in at least one axial direction with an applied electric voltage and/or on formation of at least one electrical field,
and
the piezoelectric transducer elements (2) arranged in adjacent planes can each be operated oppositely to one another such that in one plane extension of and in the adjacent plane simultaneously shortening of the length of one or more piezoelectric transducer elements (2) is caused in at least one axial direction and the assembly (1) is permanently connected to a workpiece or component with material continuity and/or with shape matching.

2. An assembly in accordance with claim 1, **characterized in that** electrodes having an alignment inclined at an angle to the longitudinal fiber axes of both planes are present at piezoelectric fibers arranged in adjacent planes.

3. An assembly in accordance with one of the preceding claims, **characterized in that** electrodes (3) having an alignment inclined at a respective angle to one another are present at plate-like piezoelectric elements arranged in adjacent planes.

4. An assembly in accordance with one of the preceding claims, **characterized in that** a plurality of electrodes (3) that are arranged at a spacing from one another are present at the individual piezoelectric transducer elements (2).

5. An assembly in accordance with the preceding claim, **characterized in that** the spacings between electrodes (3) are of different sizes.

6. An assembly in accordance with one of the preceding claims, **characterized in that** the assembly (1) is rectangular or square.

## Revendications

1. Arrangement pour le contrôle non destructif de matériaux, avec laquelle des ondes de cisaillement sont émises et détectées dans des surfaces élastiques de composants, avec un arrangement (1) d'éléments convertisseurs piézoélectriques et d'un composant ou d'une pièce, dans lequel les éléments convertisseurs piézoélectriques (2) sont superposés dans plusieurs plans et les éléments convertisseurs piézoélectriques (2) sont des fibres piézoélectriques et/ou des éléments piézoélectriques sous forme de plaquettes, qui sont reliés avec un matériau élastiquement déformable ou intégrés dans celui-ci ; et
les fibres piézoélectriques sont orientées dans un plan parallèlement entre elles et les fibres piézoélectriques dans un plan adjacent forment un angle avec les fibres piézoélectriques qui se trouvent dans l'autre plan,
ou
les éléments convertisseurs piézoélectriques en forme de plaquettes présentent une épaisseur avec laquelle un étirement ou un raccourcissement peut être obtenu lorsqu'une tension électrique est appliquée et/ou lors de la production d'au moins un champ électrique dans au moins une direction axiale,
et
les éléments convertisseurs piézoélectriques (2), qui sont disposés dans des plans adjacents, peuvent fonctionner de manière opposée entre eux, de façon à ce que, dans un plan, un allongement et dans le plan adjacent un raccourcissement de la longueur d'un ou plusieurs éléments convertisseurs piézoélectriques (2) dans au moins une direction axiale soient provoqués simultanément et
l'arrangement (1) est relié avec la pièce ou le composant de manière durable par liaison de matière et/ou par complémentarité de forme.

2. Arrangement selon la revendication 1, **caractérisé en ce que**, sur les fibres piézoélectriques qui sont disposées dans des plans adjacents, se trouvent des électrodes avec une orientation qui est inclinée en formant un angle par rapport aux axes longitudinaux des fibres des deux plans.

3. Arrangement selon l'une des revendications précédentes, **caractérisé en ce que**, sur les éléments piézoélectriques en forme de plaquettes, sui sont disposés dans des plans adjacents, se trouvent des électrodes (3) avec des orientations inclinées entre elles selon un angle.

4. Arrangement selon l'une des revendications précédentes, **caractérisé en ce que**, sur les différents éléments convertisseurs piézoélectriques (2) se trouvent plusieurs électrodes (3) qui sont distantes entre elles.

5. Arrangement selon la revendication précédente, **caractérisé en ce que** les distances entre les électrodes (3) sont différentes entre elles.

6. Arrangement selon l'une des revendications précédentes, **caractérisé en ce que** l'arrangement (1) est de forme rectangulaire ou carrée.
